# EUROPEAN PATENT APPLICATION

(11) **EP 4 848 972 A1**
(43) Date of publication of application: **02.12.2026**
(21) Application number: 26162621.2
(22) Date of filing: 05.03.2026
(51) Int. Cl.: H10W 70/60, H10W 70/65, H10W 70/685, H10W 74/01, H10W 74/10, H10W 90/10, H10W 74/15, H10W 90/00

(54) **PACKAGE SUBSTRATE AND SEMICONDUCTOR PACKAGE WITH MOLDED UNDERFILL STRUCTURE AND PACKAGE SUBSTRATE**

(30) Priority: 27.05.2025 KR 20250068640
(71) Applicant: SK hynix Inc., Bubal-eub Icheon-si Gyeonggi-do 17336 (KR)
(72) Inventor: PARK, Jin Kyoung, 17336 Icheon-si, Gyeonggi-do (KR)
(74) Representative: Isarpatent

(57) **Abstract**

A semiconductor package includes a package substrate; a semiconductor chip mounted on the package substrate by a bump; and a mold layer covering the semiconductor chip. The package substrate includes a substrate body; a bump bonding pad disposed on an upper surface of the substrate body and bonded to the bump; and a first insulating layer disposed on the upper surface of the substrate body. The first insulating layer defines a first opening extending from a side surface of the substrate body, through which the bump bonding pad is exposed.

## Description

### 1. Technical Field

The present disclosure relates to a semiconductor package having a molded underfill package structure and a package substrate.

### 2. Related Art

Flip chip technology refers to a method of mounting a semiconductor chip on a substrate by bumps. A package using flip chip technology includes a package substrate; a semiconductor chip bonded to the package substrate by bumps; an under-fill disposed in a space between the package substrate and the semiconductor chip; and a mold layer encapsulating the semiconductor chip.

The under-fill provides mechanical coupling between the package substrate and the semiconductor chip and relieves stress caused by a difference in coefficient of thermal expansion (CTE) between the package substrate and the semiconductor chip. The under-fill method may be classified as capillary under-fill (CUF) or molded underfill (MUF).

During a CUF process, the under-fill material is injected between the package substrate and the semiconductor chip using capillary action. A molding process that encapsulates the semiconductor chip and the substrate with a molding material is performed after the under-fill material is injected. During a MUF process, the molding material is filled between the package substrate and the semiconductor chip during a single molding process that forms the mold layer without a separate under-fill process.

### SUMMARY

An embodiment of the present disclosure includes a semiconductor package including a package substrate; a first semiconductor chip mounted in a first package region of the package substrate by a first bump; a second semiconductor chip mounted in a second package region of the package substrate by a second bump; and a mold layer covering the first semiconductor chip and the second semiconductor chip. The package substrate includes a substrate body; a first bump bonding pad disposed on the substrate body and bonded to the first bump; a second bump bonding pad disposed on the substrate body and bonded to the second bump; and a first insulating layer disposed on the substrate body. The first insulating layer defines a first opening, through which the substrate body is exposed in a package division region surrounding the first package region and the second package region. The first insulating layer defines a second opening adjacent to and extending from the first opening, through which the first bump bonding pad is exposed. The first insulating layer defines a third opening adjacent to and extending from the first opening, through which the second bump bonding pad is exposed.

An embodiment of the present disclosure includes a semiconductor package including a package substrate; a semiconductor chip mounted on the package substrate by a bump; and a mold layer covering the semiconductor chip. The package substrate includes a substrate body; a bump bonding pad disposed on an upper surface of the substrate body and bonded to the bump; and a first insulating layer disposed on the upper surface of the substrate body. The first insulating layer defines a first opening extending from a side surface of the substrate body, through which the bump bonding pad is exposed.

An embodiment of the present disclosure includes a package substrate including a substrate body; a first bump bonding pad disposed on the substrate body in a first package region; a second bump bonding pad disposed on the substrate body in a second package region; and a first insulating layer disposed on the substrate body. The first insulating layer defines a first opening, through which first opening the substrate body is exposed in a package division region surrounding the first package region and the second package region. The first insulating layer defines a second opening adjacent to and extending from the first opening, through which the first bump bonding pad is exposed. The first insulating layer defines a third opening adjacent to and extending from the first opening, through which the second bump bonding pad is exposed.

### BRIEF DESCRIPTION OF THE DRAWINGS

FIG. 1 is a plan view of a semiconductor package according to an embodiment of the present disclosure.
FIG. 2 is a plan view showing first package region and a second package region and a package division region of the semiconductor package of FIG. 1.
FIG. 3 is a cross-sectional view along line A-A' of FIG. 1.
FIG. 4 is a cross-sectional view along line B-B' of FIG. 1.
FIG. 5 is a cross-sectional view along line C-C' of FIG. 1.
FIG. 6 is a cross-sectional view along line D-D' of FIG. 1.
FIG. 7 is a cross-sectional view along line E-E' of FIG. 1.
FIG. 8 is a cross-sectional view along line F-F' of FIG. 1.
FIG. 9 is a plan view of a semiconductor package according to an embodiment of the present disclosure.
FIG. 10 is a cross-sectional view along line G-G' of FIG. 9.
FIG. 11 is a cross-sectional view along line H-H' of FIG. 9.
FIG. 12 is a cross-sectional view along line I-I' of FIG. 9.
FIG. 13 is a cross-sectional view along line J-J' of FIG. 9.
FIG. 14 is a cross-sectional view along line K-K' of FIG. 9.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" to another element, the elements may be connected directly or through an intervening element between the elements. When two elements are identified as "directly connected," one element is directly connected to the other element without an intervening element between the two elements.

When one element is identified as "on," "over," or "under" another element, the elements may directly contact each other or an intervening element may be disposed between the elements.

Terms such as "vertical," "horizontal," "top," "bottom," "below," "under," "on," "side," "upper," "lower," "column," "row," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

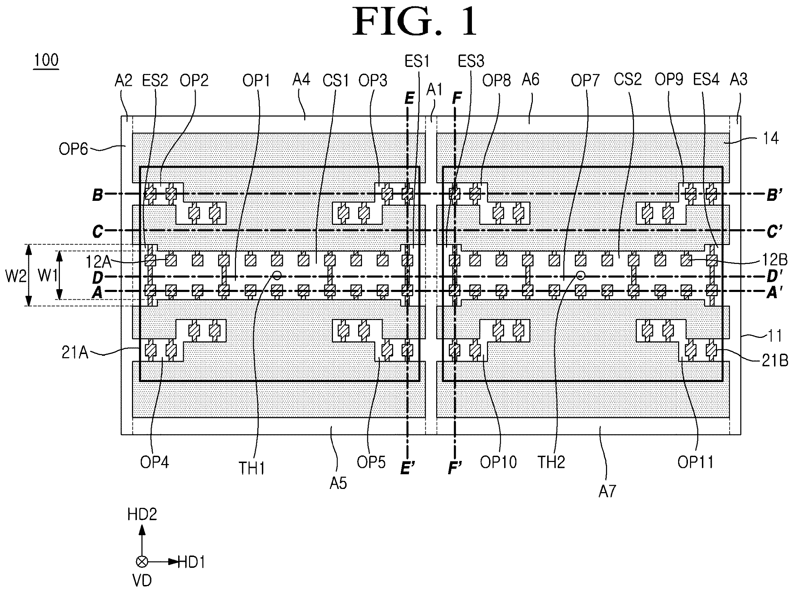

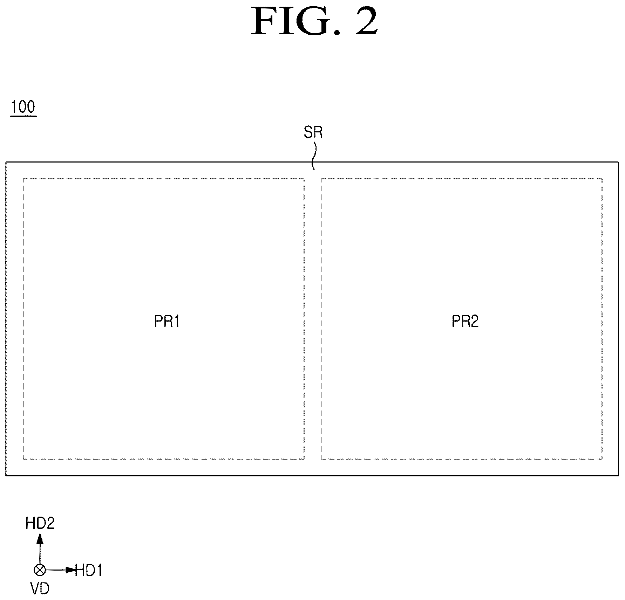

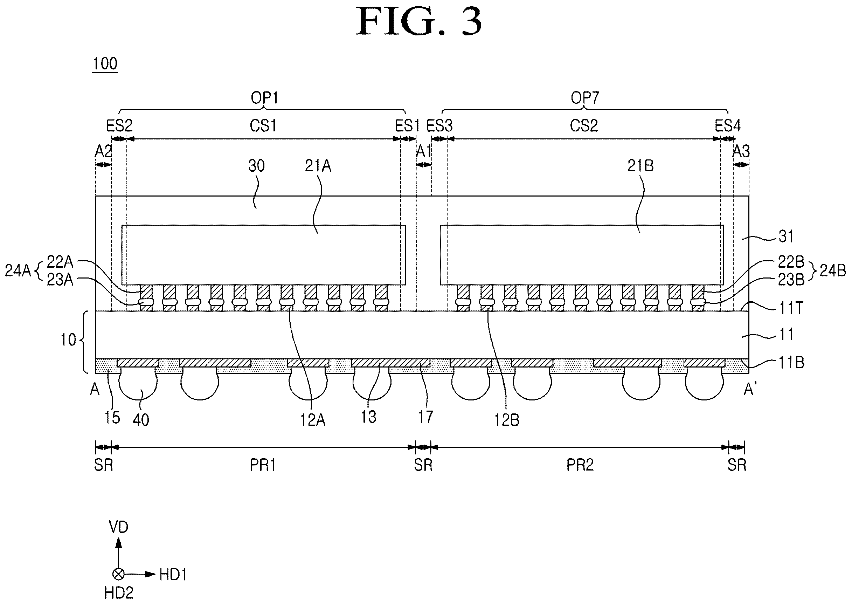

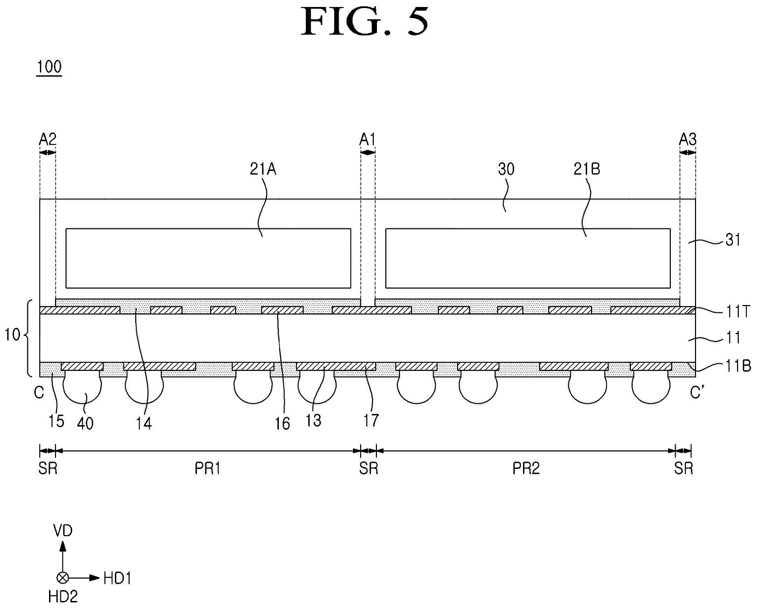

FIG. 1 is a plan view of a semiconductor package according to an embodiment of the present disclosure. FIG. 2 is a plan view illustrating a first package region, a second package region, and a package division region of the semiconductor package of FIG. 1. FIG. 3 to FIG. 8 are cross-sectional views along lines A-A', B-B', C-C', D-D', E-E', and F-F' of FIG. 1, respectively.

Referring to FIG. 1 to FIG. 8, a semiconductor package 100 according to an embodiment of the present disclosure comprises a package substrate 10, a first semiconductor chip 21A, a second semiconductor chip 21B, a mold layer 30, and external connection terminals 40. For simplicity, the mold layer 30 is not shown in FIG. 1.

The package substrate 10 comprises a substrate body 11, a first insulating layer 14, a second insulating layer 15, a first metal pattern 16, and a second metal pattern 17.

The semiconductor package 100 has a first package region PR1, a second package region PR2, and a package division region SR. The first package region PR1 is near or adjacent to the second package region PR2 in a first horizontal direction HD1. As shown in FIG. 2, the package division region SR surrounds each of the first package region PR1 and the second package region PR2. A portion of the package division region SR is provided between the first package region PR1 and the second package region PR2. In this embodiment, two package regions are consecutively disposed in the first horizontal direction HD1. It is noted that a plurality of package regions may be arranged in a two-dimensional grid along the first horizontal direction HD1 and a second horizontal direction HD2. The first horizontal direction HD1 and the second horizontal direction HD2 are two orthogonal directions parallel to the top surface of the substrate body 11.

As shown in FIG. 3 to FIG. 8, the first metal pattern 16 is disposed on an upper surface 11T of the substrate body 11. The first metal pattern 16 may include signal wiring, a ground pattern, and a power pattern. As shown in FIG. 1, FIG. 3, FIG. 4, FIG. 7, and FIG. 8, the first metal pattern 16 includes first bump bonding pads 12A and second bump bonding pads 12B. The first bump bonding pads 12A are disposed on the upper surface 11T of the substrate body 11 in the first package region PR1. The second bump bonding pads 12B are disposed on the upper surface 11T of the substrate body 11 in the second package region PR2.

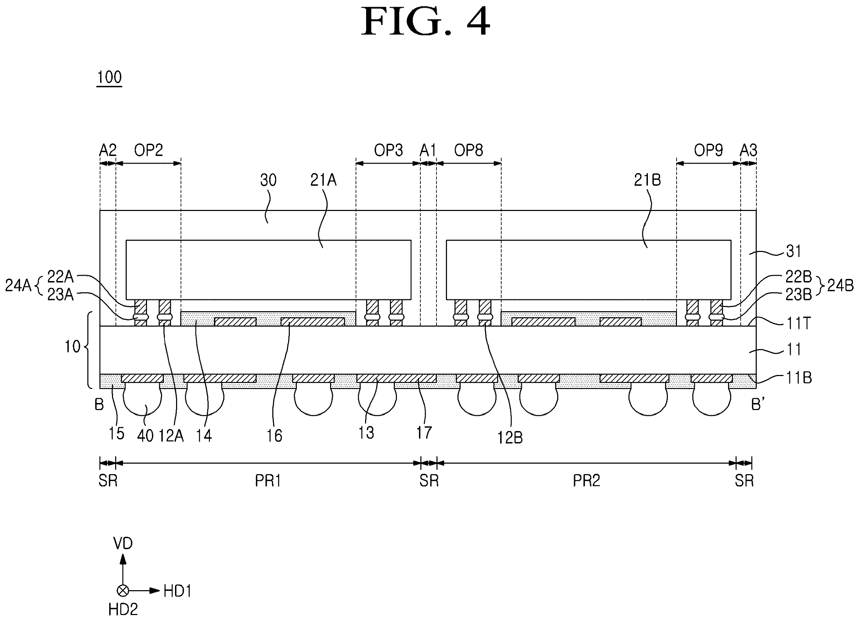

As shown in FIG. 4, FIG. 5, FIG. 7, and FIG. 8, the first insulating layer 14 is disposed on the upper surface 11T of the substrate body 11 and on the first metal pattern 16. As shown in FIG. 1 and FIG. 3 to FIG. 8, the first insulating layer 14 includes a first opening OP1 to an eleventh opening OP11. The sixth opening OP6 exposes the upper surface 11T of the substrate body 11 in the package division region SR. As shown in FIG. 1, FIG. 3, FIG. 4, and FIG. 6, the openings OP1 to OP5 are adjacent to the sixth opening OP6. The openings OP1 to OP5 extend from the sixth opening OP6 into the first package region PR1, and the first bump bonding pads 12A are exposed through the openings OP1 to OP5. The openings OP7 to OP11 are adjacent to the sixth opening OP6. The openings OP7 to OP11 extend from the sixth opening OP6 into the second package region PR2 and the second bump bonding pads 12B are exposed through the openings OP7 to OP11.

As shown in FIG. 1, the sixth opening OP6 is continuous along the package division region SR. The upper surface 11T of the substrate body 11 in the package division region SR is not covered by the first insulating layer 14. The sixth opening OP6 includes first to seventh slots A1 to A7.

As shown in FIG. 1 and FIG. 3 to FIG. 6, the first slot A1 and the second slot A2 of the sixth opening OP6 are disposed on opposite sides of the first package region PR1 in the first horizontal direction HD1. The first slot A1 and the third slot A3 of the sixth opening OP6 are disposed on opposite sides of the second package region PR2 in the first horizontal direction HD1. The first slot A1 of the sixth opening OP6 is disposed between the first package region PR1 and the second package region PR2. The second slot A2 of the sixth opening OP6 is disposed on an opposite side of the first package region PR1 with respect to the first slot A1 in the first horizontal direction HD1. The third slot A3 of the sixth opening OP6 is disposed on an opposite side of the second package region PR2 with respect to the first slot A1 of the sixth opening OP6 in the first horizontal direction HD1.

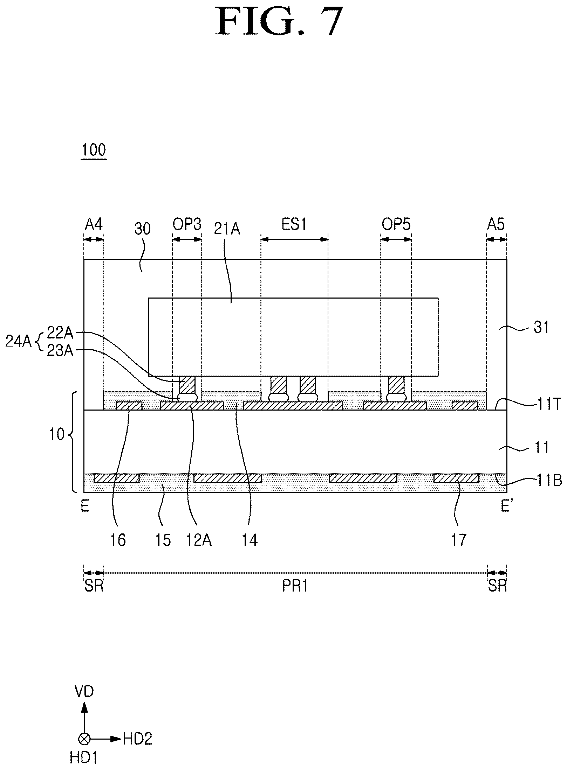

As shown in FIG. 1 and FIG. 7, the fourth slot A4 and the fifth slot A5 of the sixth opening OP6 are disposed on opposite sides of the first package region PR1 in the second horizontal direction HD2. As shown in FIG. 1, a first end of the fourth slot A4 of the sixth opening OP6 in the first horizontal direction HD1 is adjacent to the first slot A1, and a second end of the fourth slot A4 of the sixth opening OP6 in the first horizontal direction HD1 is adjacent to the second slot A2 of the sixth opening OP6. A first end of the fifth slot A5 of the sixth opening OP6 is adjacent to the first slot A1, and a second end of the fifth slot A5 of the sixth opening OP6 is adjacent to the second slot A2 of the sixth opening OP6.

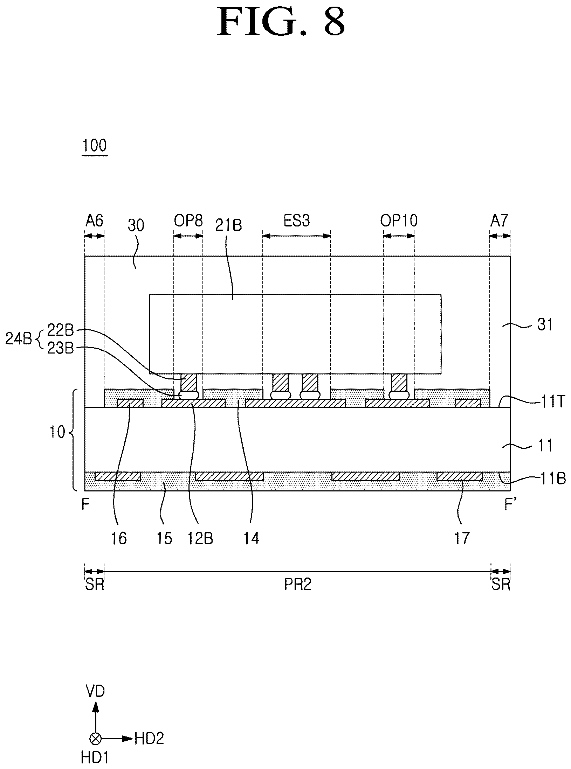

As shown in FIG. 1 and FIG. 8, the sixth slot A6 and the seventh slot A7 of the sixth opening OP6 are disposed on opposite sides of the second package region PR2 in the second horizontal direction HD2. As shown in FIG. 1, a first end of the sixth slot A6 of the sixth opening OP6 in the first horizontal direction HD1 is adjacent to the first slot A1, and a second end of the sixth slot A6 of the sixth opening OP6 in the first horizontal direction HD1 is adjacent to the third slot A3 of the sixth opening OP6. A first end of the seventh slot A7 of the sixth opening OP6 in the first horizontal direction HD1 is adjacent to the first slot A1, and a second end of the seventh slot A7 of the sixth opening OP6 in the first horizontal direction HD1 is adjacent to the third slot A3 of the sixth opening OP6.

As shown in FIG. 1, FIG. 3, and FIG. 6, the first opening OP1 extends across the first package region PR1 in the first horizontal direction HD1. As shown in FIG. 1 and FIG. 3, a plurality of rows of the first bump bonding pads 12A is disposed in a central section of the first package region PR1. The first opening OP1 exposes the first bump bonding pads 12A disposed in a plurality of rows in the central section of the first package region PR1.

As shown in FIG. 1, FIG. 3, and FIG. 6, a first end of the first opening OP1 is adjacent to the first slot A1 and a second end of the first opening OP1 is adjacent to the second slot A2 of the sixth opening OP6. The first opening OP1 includes a first recess ES1 adjacent to the first slot A1 of the sixth opening OP6, a second recess ES2 adjacent to the second slot A2 of the sixth opening OP6, and a first cavity CS1 between the first recess ES1 and the second recess ES2. As shown in FIG. 1, a width of the first recess ES1 in the second horizontal direction HD2 is greater than a width of the first cavity CS1 in the second horizontal direction HD2. A width of the second recess ES2 in the second horizontal direction HD2 is greater than a width of the first cavity CS1 in the second horizontal direction HD2. The width of the first cavity CS1 in the second horizontal direction HD2 is W1, and the width of the first recess ES1 and the second recess ES2 in the second horizontal direction HD2 is W2. W2 is greater than W1.

As shown in FIG. 1, the width of each of the first recess ES1 and the second recess ES2 in the second horizontal direction HD2 is greater than the width of the first cavity CS1 in the second horizontal direction HD2, although the present disclosure is not limited to this example. In an example, the width of at least one of the first recess and the second recess in the second horizontal direction is greater than the width of the first cavity in the second horizontal direction. In an example, the widths of the first recess and the second recess in the second horizontal direction are equal to the width of the first cavity in the second horizontal direction.

As shown in FIG. 1, the second opening OP2 is disposed between the fourth slot A4 of the sixth opening OP6 and the first opening OP1. As shown in FIG. 1 and FIG. 4, the second opening OP2 extends into the interior of the first package region PR1 from an outer perimeter of the first package region PR1, which perimeter is adjacent to the second slot A2 of the sixth opening OP6. As shown in FIG. 1, the first bump bonding pads 12A disposed between the fourth slot A4 of the sixth opening OP6 and the first opening OP1 are exposed through the second opening OP2. As shown in FIG. 1 and FIG. 4, one end of the second opening OP2 is adjacent to the second slot A2 of the sixth opening OP6. The second opening OP2 is in communication with the sixth opening OP6.

As shown in FIG. 1 and FIG. 7, the third opening OP3 is disposed between the fourth slot A4 of the sixth opening OP6 and the first opening OP1. As shown in FIG. 1 and FIG. 4, the third opening OP3 extends into the interior of the first package region PR1 from the outer perimeter of the first package region PR1, which perimeter is adjacent to the first slot A1 of the sixth opening OP6. As shown in FIG. 1, the first bump bonding pads 12A disposed between the fourth slot A4 of the sixth opening OP6 and the first opening OP1 are exposed through the third opening OP3. As shown in FIG. 1 and FIG. 4, one end of the third opening OP3 is adjacent to the first slot A1 of the sixth opening OP6. The third opening OP3 is in communication with the sixth opening OP6.

As shown in FIG. 1, the fourth opening OP4 is disposed between the fifth slot A5 of the sixth opening OP6 and the first opening OP1. The fourth opening OP4 extends into the interior of the first package region PR1 from the outer perimeter of the first package region PR1, which perimeter is adjacent to the second slot A2 of the sixth opening OP6. The first bump bonding pads 12A disposed between the fifth slot A5 of the sixth opening OP6 and the first opening OP1 are exposed through the fourth opening OP4. One end of the fourth opening OP4 is adjacent to the second slot A2 of the sixth opening OP6. The fourth opening OP4 is in communication with the sixth opening OP6.

As shown in FIG. 1 and FIG. 7, the fifth opening OP5 is disposed between the fifth slot A5 of the sixth opening OP6 and the first opening OP1. As shown in FIG. 1, the fifth opening OP5 extends into the interior of the first package region PR1 from the outer perimeter of the first package region PR1, which perimeter is adjacent to the first slot A1 of the sixth opening OP6. The first bump bonding pads 12A disposed between the fifth slot A5 of the sixth opening OP6 and the first opening OP1 are exposed through the fifth opening OP5. One end of the fifth opening OP5 is adjacent to the first slot A1 of the sixth opening OP6. The fifth opening OP5 is in communication with the sixth opening OP6.

As shown in FIG. 1, the first bump bonding pads 12A exposed through each of openings OP2, OP3, OP4, and OP5 are not arranged or aligned in a straight line along the first horizontal direction HD1. Each of the openings OP2, OP3, OP4, and OP5 may have a curved or circular shape through which the first bump bonding pads 12A are exposed. Although the first bump bonding pads 12A exposed through each of the openings OP2, OP3, OP4, and OP5 are not arranged in a straight line along the first horizontal direction HD1 in FIG. 1, the present disclosure is not limited to this example. In an example, the first bump bonding pads exposed through each of the second to fifth openings are arranged in a straight line along the first horizontal direction. In this example, each of the second to fifth openings may have a linear or rectangular shape extending along the first horizontal direction.

As shown in FIG. 1, FIG. 3, and FIG. 6, the seventh opening OP7 extends across the second package region PR2 in the first horizontal direction HD1. The seventh opening OP7 is aligned with the first opening OP1 in the first horizontal direction HD1.

As shown in FIG. 1 and FIG. 3, a plurality of rows of the second bump bonding pads 12B is disposed in the central section of the second package region PR2. The second bump bonding pads 12B disposed in a plurality of rows in the central section of the second package region PR2 are exposed through the seventh opening OP7. A first end of the seventh opening OP7 is adjacent to the first slot A1, and a second end of the seventh opening OP7 is adjacent to the third slot A3 of the sixth opening OP6. As shown in FIG. 1, FIG. 3, and FIG. 6, the seventh opening OP7 includes a third recess ES3 adjacent to the first slot A1 of the sixth opening OP6, a fourth recess ES4 adjacent to the third slot A3 of the sixth opening OP6, and a second cavity CS2 between the third recess ES3 and the fourth recess ES4. As shown in FIG. 1, a width of the third recess ES3 in the second horizontal direction HD2 is greater than a width of the second cavity CS2 in the second horizontal direction HD2. A width of the fourth recess ES4 in the second horizontal direction HD2 is greater than a width of the second cavity CS2 in the second horizontal direction HD2. The width of the second cavity CS2 in the second horizontal direction HD2 is W1, and the width of the third recess ES3 and the fourth recess ES4 in the second horizontal direction HD2 is W2. W2 is greater than W1.

As shown in FIG. 1, the width of each of the third recess ES3 and the fourth recess ES4 in the second horizontal direction HD2 is greater than the width of the second cavity CS2 in the second horizontal direction HD2, although the present disclosure is not limited to this example. In an example, the width of at least one of the third recess and the fourth recess in the second horizontal direction is greater than the width of the second cavity in the second horizontal direction. In an example, the widths of the third recess and the fourth recess in the second horizontal direction are equal to the width of the second cavity in the second horizontal direction.

As shown in FIG. 1 and FIG. 8, the eighth opening OP8 is disposed between the sixth slot A6 of the sixth opening OP6 and the seventh opening OP7. As shown in FIG. 1, the eighth opening OP8 extends into the interior of the second package region PR2 from the outer perimeter of the second package region PR2, which perimeter is adjacent to the first slot A1 of the sixth opening OP6. The second bump bonding pads 12B disposed between the sixth slot A6 of the sixth opening OP6 and the seventh opening OP7 are exposed through the eighth opening OP8. One end of the eighth opening OP8 is adjacent to the first slot A1 of the sixth opening OP6. The eighth opening OP8 is in communication with the sixth opening OP6.

As shown in FIG. 1, the ninth opening OP9 is disposed between the sixth slot A6 of the sixth opening OP6 and the seventh opening OP7. The ninth opening OP9 extends into the interior of the second package region PR2 from the outer perimeter of the second package region PR2, which perimeter is adjacent to the third slot A3 of the sixth opening OP6. The second bump bonding pads 12B disposed between the sixth slot A6 of the sixth opening OP6 and the seventh opening OP7 are exposed through the ninth opening OP9. One end of the ninth opening OP9 is adjacent to the third slot A3 of the sixth opening OP6. The ninth opening OP9 is in communication with the sixth opening OP6.

As shown in FIG. 1 and FIG. 8, the tenth opening OP10 is disposed between the seventh slot A7 of the sixth opening OP6 and the seventh opening OP7. As shown in FIG. 1, the tenth opening OP10 extends into the interior of the second package region PR2 from the outer perimeter of the second package region PR2, which perimeter is adjacent to the first slot A1 of the sixth opening OP6. The second bump bonding pads 12B disposed between the seventh slot A7 of the sixth opening OP6 and the seventh opening OP7 are exposed through the tenth opening OP10. The tenth opening OP10 is adjacent to the first slot A1 of the sixth opening OP6. The tenth opening OP10 is in communication with the sixth opening OP6.

As shown in FIG. 1, the eleventh opening OP11 is disposed between the seventh slot A7 of the sixth opening OP6 and the seventh opening OP7. The eleventh opening OP11 extends into the interior of the second package region PR2 from the outer perimeter of the second package region PR2, which perimeter is adjacent to the third slot A3 of the sixth opening OP6. The second bump bonding pads 12B disposed between the seventh slot A7 of the sixth opening OP6 and the seventh opening OP7 are exposed through the eleventh opening OP11. One end of the eleventh opening OP11 is adjacent to the third slot A3 of the sixth opening OP6. The eleventh opening OP11 is in communication with the sixth opening OP6.

As shown in FIG. 1, the second bump bonding pads 12B exposed through each of the openings OP8, OP9, OP10, and OP11 are not arranged or aligned in a straight line along the first horizontal direction HD1. Each of the eighth to eleventh openings may have a curved or circular shape through which the second bump bonding pads 12B are exposed. Although the second bump bonding pads exposed through each of the eighth to eleventh openings are not aligned along the first horizontal direction HD1 in FIG. 1, the present disclosure is not limited to this example. In an example, the second bump bonding pads exposed through each of the eighth to eleventh openings are aligned in a straight line along the first horizontal direction. In this example, each of the eighth to eleventh openings may have a linear or rectangular shape extending along the first horizontal direction.

In FIG. 1 to FIG. 8, all of the openings are adjacent to the sixth opening OP6, but the present disclosure is not limited to this example. In an example, an additional opening that is not adjacent to the sixth opening OP6 may be further formed in the insulating layer.

As shown in FIG. 3 to FIG. 8, the second metal pattern 17 is disposed on a lower surface 11B of the substrate body 11. The second metal pattern 17 includes a ball land 13. The second insulating layer 15 is disposed on the lower surface 11B of the substrate body 11 and on the second metal pattern 17. As shown in FIG. 3 to FIG. 5, the second insulating layer 15 includes an opening through which the ball land 13 is exposed. The external connection terminal 40 is attached to the ball land 13. The external connection terminal 40 may include a solder ball.

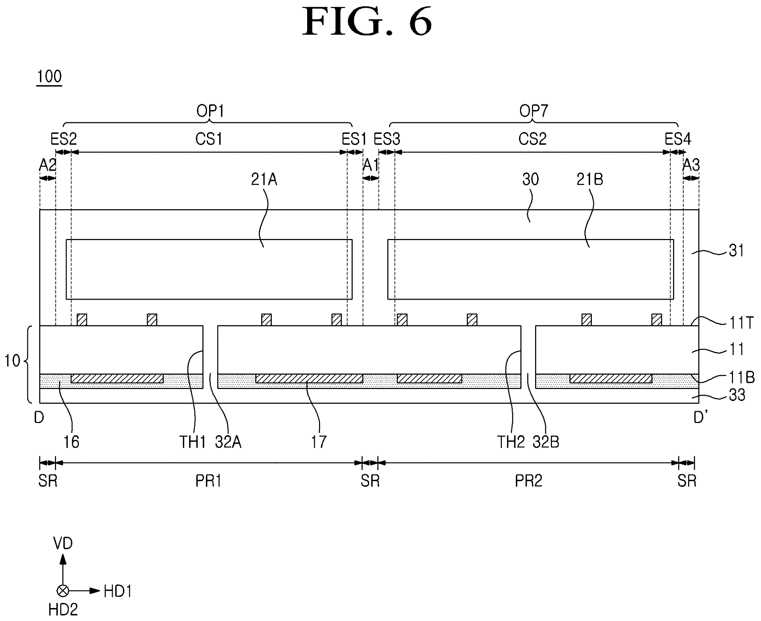

As shown in FIG. 6, a first through-hole TH1 and a second through-hole TH2 vertically extend through the package substrate 10. The first through-hole TH1 vertically extends through the substrate body 11 exposed through the first opening OP1. The second through-hole TH2 vertically extend through the substrate body 11 exposed through the seventh opening OP7.

During a molding process that forms the mold layer 30, air escapes through the through-holes TH1 and TH2, and the first and second through-holes are filled with molding material. The through-holes TH1 and TH2 functions as a vent for exhaust in an example.

The first semiconductor chip 21A is disposed in the first package region PR1 of the package substrate 10. The first semiconductor chip 21A is mounted to the package substrate 10 by first bumps 24A. The first semiconductor chip 21A is electrically and physically connected to the package substrate 10 via the first bumps 24A. The first bump 24A includes a first metal layer 22A and a first solder layer 23A. The first metal layer 22A is disposed under a lower surface of the first semiconductor chip 21A, and the first solder layer 23A is disposed under the first metal layer 22A. The first solder layer 23A is bonded to the first bump bonding pad 12A.

The second semiconductor chip 21B is disposed in the second package region PR2 of the package substrate 10. The second semiconductor chip 21B is mounted to the package substrate 10 by second bumps 24B. The second semiconductor chip 21B is electrically and physically connected to the package substrate 10 via the second bumps 24B. The second bump 24B includes a second metal layer 22B and a second solder layer 23B. The second metal layer 22B is disposed under a lower surface of the second semiconductor chip 21B, and the second solder layer 23B is disposed under the second metal layer 22B. The second solder layer 23B is bonded to the second bump bonding pad 12B.

Each of the semiconductor chips 21A and 21B includes a core circuit region and a peripheral circuit region. A core circuit is disposed in the core circuit region. The core circuit includes circuits that perform the main functions of the semiconductor chip. When the semiconductor chip is a memory chip, the core circuit includes memory cells. A peripheral circuit is disposed in the peripheral circuit region. The peripheral circuit may include circuits that support the operation of the core circuit or perform interfacing with external devices. The peripheral circuit includes input/output interface circuits and timing control circuits. The peripheral circuit region may be in the central section of the chip along the first horizontal direction HD1. The core circuit region may be outside the peripheral circuit region.

The bumps 24A and 24B include signal bumps, power bumps, and ground bumps. The power and ground bumps are disposed in the peripheral circuit region and an outer region of the peripheral circuit region. The signal bumps are disposed in the peripheral circuit region. Because the peripheral circuit region includes power and ground bumps as well as signal bumps, the quantity of bumps disposed in the peripheral circuit region is greater than the quantity of bumps disposed in the outer region of the peripheral circuit region. The first bumps 24A may be arranged in a plurality of rows in the peripheral circuit region of the first semiconductor chip 21A. The second bumps 24B may be arranged in a plurality of rows in the peripheral circuit region of the second semiconductor chip 21B.

The first bumps 24A disposed in the peripheral circuit region of the first semiconductor chip 21A are bonded to the first bump bonding pads 12A exposed through the first opening OP1 of the first insulating layer 14. The first bumps 24A disposed in the outer region of the peripheral circuit region of the first semiconductor chip 21A are bonded to the first bump bonding pads 12A exposed through the openings OP2, OP3, OP4, and OP5 of the first insulating layer 14.

The second bumps 24B disposed in the peripheral circuit region of the second semiconductor chip 21B are bonded to the second bump bonding pads 12B exposed through the seventh opening OP7 of the first insulating layer 14. The second bumps 24B disposed in the outer region of the peripheral circuit region of the second semiconductor chip 21B are bonded to the second bump bonding pads 12B exposed through the openings OP8, OP9, OP10, and OP11 of the first insulating layer 14.

The mold layer 30 includes a top mold section 31, a first extension 32A, a second extension 32B, a bottom mold section 33. The mold layer 30 may be formed by a molding process using liquid molding material. The molding material may include an epoxy molding compound (EMC). The epoxy molding compound may include a resin and a filler.

The top mold section 31 fills the spaces between the first semiconductor chip 21A and the package substrate 10 and between the second semiconductor chip 21B and the package substrate 10, and covers the first semiconductor chip 21A and the second semiconductor chip 21B.

During the molding process, vacuum evacuation may be performed through the first through-hole TH1 and the second through-hole TH2 of the package substrate 10. Due to the pressure difference between the pressure at which the molding material is injected and the vacuum evacuation through the first and second through-holes, the molding material may flow into the spaces between the first semiconductor chip 21A and the package substrate 10 and between the second semiconductor chip 21B and the package substrate 10. Accordingly, the spaces between the first semiconductor chip 21A and the package substrate 10 and between the second semiconductor chip 21B and the package substrate 10 are filled with the top mold section 31. The top mold section 31 covers the semiconductor chips 21A and 21B and the bumps 24A and 24B for protection from the external environment.

During the molding process, the molding material is provided in a liquid state. In the region where the first semiconductor chip 21A is disposed, a flow path for the molding material is limited to the space between the first semiconductor chip 21A and the package substrate 10 and between the first semiconductor chip 21A and the mold cavity. In the region where the second semiconductor chip 21B is disposed, the flow path for the molding material is limited to the space between the second semiconductor chip 21B and the package substrate 10 and between the second semiconductor chip 21B and the mold cavity.

A space between the first semiconductor chip 21A and the second semiconductor chip 21B functions as a main path through which the molding material is injected. Because the sixth opening OP6 is continuous along the package division region SR, the injection path is increased in size, which may increase the flow rate of the molding material along the package division region SR.

The flow of the molding material may be hindered by the bumps 24A and 24B, thereby causing a reduction in flow rate of the molding material around the first and second bumps. The openings OP1, OP2, OP3, OP4, OP5, OP7, OP8, OP9, OP10, and OP11 that are adjacent to the sixth opening OP6 guide the molding material flowing along the package division region SR to be injected around the first and second bumps. Accordingly, the flow rate of the molding material around the first and second bumps may be improved.

In regions where the bumps 24A and 24B are not disposed, the first insulating layer 14 is disposed on the substrate body 11. Due to the thickness of the first insulating layer 14, the gap height between the semiconductor chips is reduced in regions where the first insulating layer is present compared to regions where the first insulating layer is not present. In such regions with a shorter gap height, the flow rate of the molding material is decreased, thus slowing down the flow of molding material in regions where the first insulating layer 14 is disposed.

Although the flow of the molding material is slowed in regions with the bumps 24A and 24B due to the bump structures, the presence of the openings in the first insulating layer 14 may help minimize any reduction in flow speed. The presence of the first insulating layer 14 in areas without the first and second bumps can suppress an excessive increase in the flow speed of the molding material. According to the present disclosure, the variation in the flow rate of the molding material caused by the distribution of the bumps 24A and 24B may be reduced or suppressed. Thus, the molding material may be uniformly filled in the space between the package substrate 10 and the semiconductor chips 21A and 21B, thereby preventing or suppressing the formation of voids within the mold layer 30.

The openings OP1 to OP11 are filled with the molding material. The top mold section 31 contacts the upper surface 11T of the substrate body 11 exposed through the first to eleventh openings. In an embodiment, the top mold section 31 covers the upper surfaces of the semiconductor chips 21A and 21B. In an example, the top mold section does not cover the upper surfaces of the first and second semiconductor chips.

During the molding process, the molding material flows into the through-holes TH1 and TH2. As shown in FIG. 6, the first extension 32A within the first through-hole TH1, the second extension 32B within the second through-hole TH2, and a bottom mold section 33 below the second insulating layer 15 are formed. The bottom mold section 33 is disposed under the second insulating layer 15 and is connected to the extensions 32A and 32B. The bottom mold section 33 may have a rectangular shape or a linear shape extending in the second horizontal direction HD2.

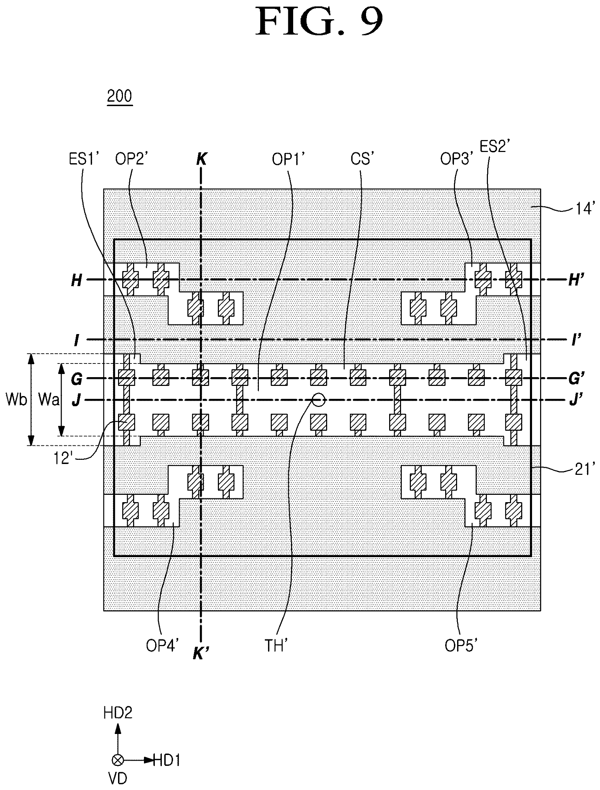

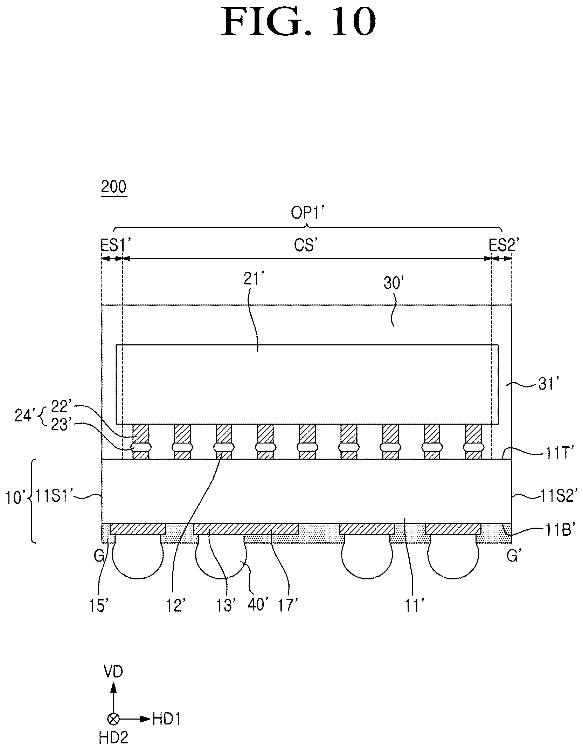

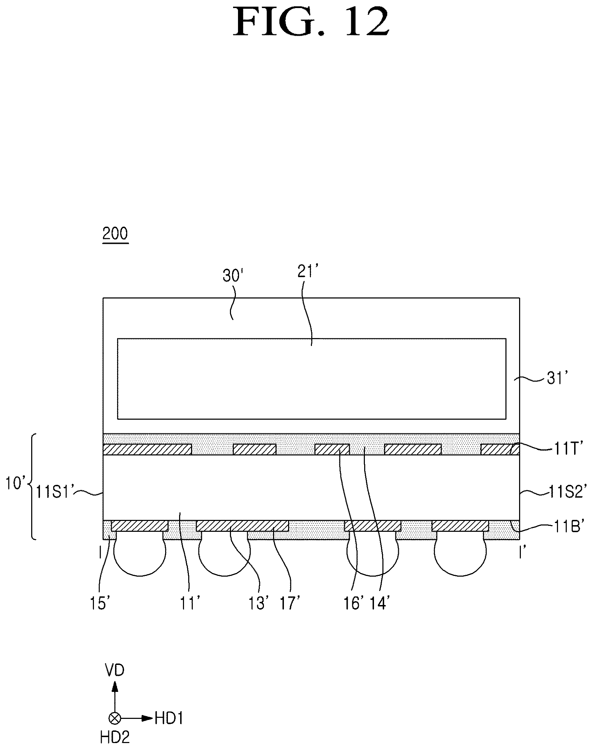

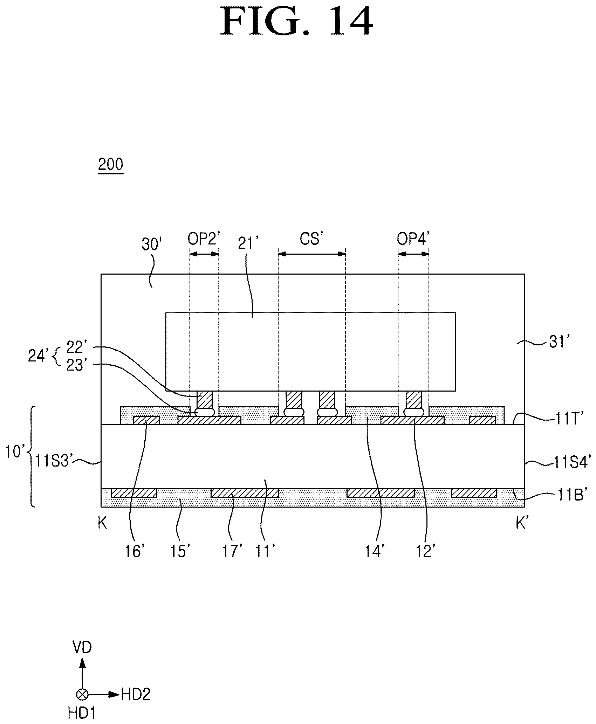

FIG. 9 is a plan view of a semiconductor package according to an embodiment of the present disclosure. FIG. 10 to FIG. 14 are cross-sectional views along lines G-G', H-H', I-I', J-J', and K-K' of FIG. 9, respectively.

Referring to FIG. 9 to FIG. 14, the semiconductor package 200 according to an embodiment of the present disclosure includes a package substrate 10', a semiconductor chip 21', a mold layer 30', and external connection terminals 40'. For simplicity, the mold layer 30' is not shown in FIG. 9.

The semiconductor package 200 according to an embodiment may be formed by singulating or separating individual semiconductor packages 100 described with reference to FIG. 1 to FIG. 8 along the package division region SR.

The package substrate 10' includes a substrate body 11', a second insulating layer 15', a first metal pattern 16', and a second metal pattern 17'.

As shown in FIG. 10 to FIG.14, the substrate body 11' has an upper surface 11T', a lower surface 11B', a first side surface 11S1', a second side surface 11S2', a third side surface 11S3', and a fourth side surface 11S4'. The first side surface 11S1' faces an opposite direction than the second side surface 11S2', for example, in a first horizontal direction HD1, and the third side surface 11S3' faces an opposite direction than the fourth side surface 11S4', for example, in a second horizontal direction HD2.

As shown in FIG. 10, FIG. 11, and FIG. 14, the first metal pattern 16' is disposed on the upper surface 11T' of the substrate body 11'. The first metal pattern 16' may include signal wiring, a ground pattern, and a power pattern. The first metal pattern 16' includes bump bonding pads 12'.

As shown in FIG. 9, FIG. 11, FIG. 12, and FIG. 14, the first insulating layer 14' is disposed on the upper surface 11T' of the substrate body 11' and on the first metal pattern 16'. As shown in FIG. 9 to FIG. 11 and FIG. 13 to FIG. 14, the first insulating layer 14' includes openings OP1', OP2', OP3', OP4', and OP5'. Each of the openings OP1' to OP5' is adjacent to at least one of the side surfaces 11S1', 11S2', 11S3', and 11S4' of the substrate body 11' and extends from at least one of the side surfaces to expose the bump bonding pads 12'.

As shown in FIG. 9, FIG. 10, and FIG. 13, the first opening OP1' extends across the upper surface 11T' of the substrate body 11' in the first horizontal direction HD1. As shown in FIG. 9 and FIG. 10, the first opening OP1' exposes bump bonding pads 12' arranged in multiple rows in the central section of the substrate body 11'. A first end of the first opening OP1' is adjacent to the first side surface 11S1' of the substrate body 11', and a second end of the first opening OP1' is adjacent to the second side surface 11S2' of the substrate body 11'.

As shown in FIG. 9, FIG. 10, and FIG. 13, the first opening OP1' includes a first recess ES1' adjacent to the first side surface 11S1' of the substrate body 11', a second recess ES2' adjacent to the second side surface 11S2' of the substrate body 11', and a cavity CS' adjacent to the first recess ES1' and the second recess ES2'.

As shown in FIG. 9, the width of the first recess ES1' in the second horizontal direction HD2 is greater than the width of the cavity CS' in the second horizontal direction HD2. The width of the second recess ES2' in the second horizontal direction HD2 is greater than the width of the cavity CS' in the second horizontal direction HD2. The width of the cavity CS' in the second horizontal direction HD2 is Wa, and the width of the first recess ES1' and the second recess ES2' in the second horizontal direction HD2 is Wb. Wb is greater than Wa.

As shown in FIG. 9, the widths of the first recess ES1' and the second recess ES2' in the second horizontal direction HD2 are greater than the width of the cavity CS' in the second horizontal direction HD2, although the present disclosure is not limited to this example. In an example, a width of at least one of the first recess and the second recess in the second horizontal direction is greater than the width of the cavity in the second horizontal direction. In an example, the widths of the first recess and the second recess in the second horizontal direction are equal to the width of the cavity CS' in the second horizontal direction.

As shown in FIG. 10, FIG. 11, and FIG. 14, bumps 24' corresponding to the bump bonding pads 12' exposed through the first opening OP1' are disposed. The flow speed of the molding material is slowed due to the resistance of the bumps 24' during the molding process. According to an embodiment of the present disclosure, the width of the first recess ES1' and/or the second recess ES2' in the second horizontal direction HD2 is configured to be greater than the width of the cavity CS' in the second horizontal direction HD2, such that the molding material may be injected into the first opening OP1' at a higher speed. Accordingly, the flow speed of the molding material around the bumps 24' disposed on the area exposed through the first opening OP1' may not decrease.

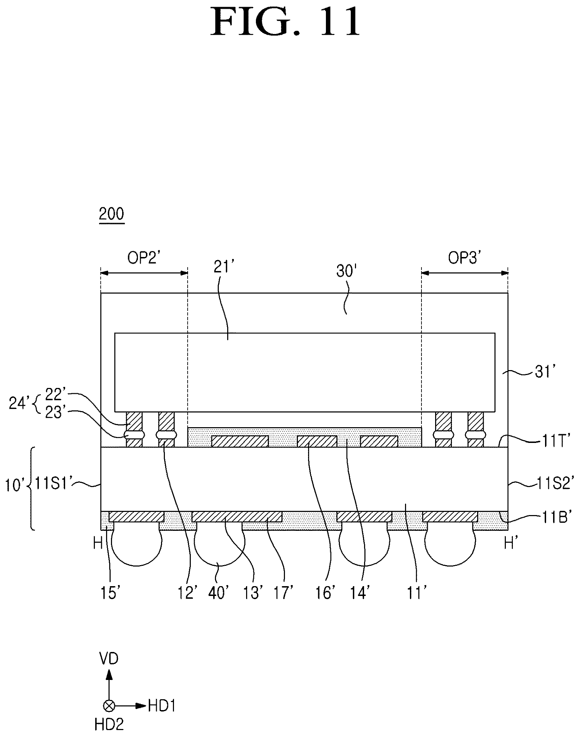

As shown in FIG. 9 and FIG. 11, the second opening OP2' is adjacent to the first side surface 11S1' of the substrate body 11', and the bump bonding pads 12' are exposed through the second opening OP2'. The third opening OP3' is adjacent to the second side surface 11S2' of the substrate body 11', and the bump bonding pads 12' are exposed through the third opening OP3'.

As shown in FIG. 9, the fourth opening OP4' is adjacent to the first side surface 11S1' of the substrate body 11', and the bump bonding pads 12' are exposed through the fourth opening OP4'. The fifth opening OP5' is adjacent to the second side surface 11S2' of the substrate body 11', and the bump bonding pads 12' are exposed through the fifth opening OP5'. In FIG. 9 to FIG. 14, all of the openings are adjacent to the side surface 11S1' or 11S2' of the substrate body 11', but the present disclosure is not limited to this example. In another example, an additional opening that is not adjacent to the side surfaces of the substrate body may be further formed in the insulating layer.

As shown in FIG. 9, the bump bonding pads 12' exposed through each of the openings OP2', OP3', OP4', and OP5' are not aligned in a straight line along the first horizontal direction HD1. Each of the openings OP2', OP3', OP4', and OP5' may have a curved or circular shape to expose the bump bonding pads 12' that are not aligned in a straight line. Although the bump bonding pads exposed through the each of openings OP2', OP3', OP4', and OP5' are not aligned in a straight line along the first horizontal direction HD1 in FIG. 9, the present disclosure is not limited to this example. In an example, the bump bonding pads exposed through each of the second to fifth openings may be aligned in a straight line along the first horizontal direction. In this example, each of the second to fifth openings may have a linear or rectangular shape extending along the first horizontal direction.

As shown in FIG. 10 to FIG. 14, the second metal pattern 17' is disposed on the lower surface 11B' of the substrate body 11'. As shown in FIG. 10 to FIG. 12, the second metal pattern 17' includes a ball land 13'. The second insulating layer 15' is disposed on the lower surface 11B' of the substrate body 11' and includes an opening through which the ball land 13' is exposed. An external connection terminal 40' is attached to the ball land 13'. The external connection terminal 40' may include a solder ball.

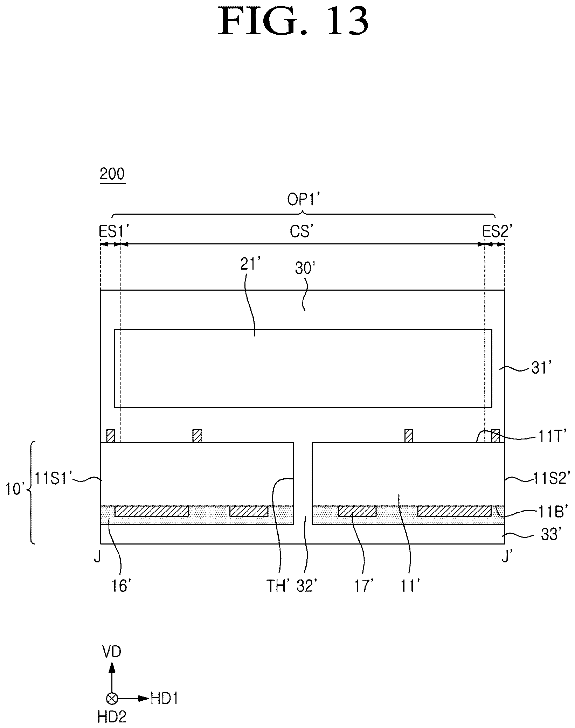

As shown in FIG. 9 and FIG. 13, a through-hole TH' vertically extends through the package substrate 10'. The through-hole TH' vertically extends through the substrate body 11' exposed through the first opening OP1'.

During a molding process that forms the mold layer 30', air escapes through the through-hole TH', and the through-hole TH' is filled with the molding material. The through-hole TH' may functions as a vent for exhaust in an example.

The semiconductor chip 21' is disposed on the package substrate 10'. The semiconductor chip 21' is mounted on the package substrate 10' by bumps 24'. The bumps 24' include a metal layer 22' and a solder layer 23'. The metal layer 22' is disposed under a lower surface of the semiconductor chip 21', and the solder layer 23' is disposed under the metal layer 22'. The solder layer 23' is bonded to the bump bonding pads 12'.

The mold layer 30' includes a top mold section 31', an extension 32', and a bottom mold section 33'. The mold layer 30' may be formed by a molding process using a liquid molding material. The molding material may include an epoxy molding compound (EMC).

The top mold section 31' fills the space between the semiconductor chip 21' and the package substrate 10' and covers the semiconductor chip 21'. The top mold section 31' covers the semiconductor chip 21' and the bumps 24' for protection from the external environment.

The openings OP1' to OP7' are filled with the molding material. As shown in FIG. 10, FIG. 11, FIG. 13, and FIG. 14, the top mold section 31' contacts the upper surface 11T' of the substrate body 11' exposed through the openings OP1' to OP7'. In an embodiment, the top mold section 31' covers the upper surface of the semiconductor chip 21'. In an example, the top mold section does not cover the upper surface of the semiconductor chip.

As shown in FIG. 13, the extension 32' fills the through-hole TH'. The bottom mold section 33' is disposed below the second insulating layer 15' and is connected to the extension 32'. The bottom mold section 33' may be configured in a rectangular shape or a linear shape extending in the first horizontal direction HD1.

A semiconductor package of the present disclosure comprising: a package substrate; a first semiconductor chip mounted in a first package region of the package substrate by a first bump; a second semiconductor chip mounted in a second package region of the package substrate by a second bump; and a mold layer covering the first semiconductor chip and the second semiconductor chip. The package substrate comprises: a substrate body; a first bump bonding pad disposed on the substrate body and bonded to the first bump; a second bump bonding pad disposed on the substrate body and bonded to the second bump; and a first insulating layer disposed on the substrate body. The first insulating layer defines a first opening, through which the substrate body is exposed in a package division region surrounding the first package region and the second package region. The first insulating layer defines a second opening adjacent to and extending from the first opening, through which the first bump bonding pad is exposed. The first insulating layer defines a third opening adjacent to and extending from the first opening, through which the second bump bonding pad is exposed.

A semiconductor package of the present disclosure comprising: a package substrate; a semiconductor chip mounted on the package substrate by a bump; and a mold layer covering the semiconductor chip. The package substrate comprises: a substrate body; a bump bonding pad disposed on an upper surface of the substrate body and bonded to the bump; and a first insulating layer disposed on the upper surface of the substrate body. The first insulating layer defines a first opening extending from a side surface of the substrate body, through which the bump bonding pad is exposed.

A package substrate of the present disclosure comprising: a substrate body; a first bump bonding pad disposed on the substrate body in a first package region; a second bump bonding pad disposed on the substrate body in a second package region; and a first insulating layer disposed on the substrate body. The first insulating layer defines a first opening, through which the substrate body is exposed in a package division region surrounding the first package region and the second package region. The first insulating layer defines a second opening adjacent to and extending from the first opening, through which the first bump bonding pad is exposed. The first insulating layer defines a third opening adjacent to and extending from the first opening, through which the second bump bonding pad is exposed.

While the detailed embodiments of the present disclosure are disclosed in the present disclosure, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope.

## Claims

1. A semiconductor package comprising:
a package substrate;
a first semiconductor chip mounted in a first package region of the package substrate by a first bump;
a second semiconductor chip mounted in a second package region of the package substrate by a second bump; and
a mold layer covering the first semiconductor chip and the second semiconductor chip;
wherein the package substrate comprises:
a substrate body;
a first bump bonding pad disposed on the substrate body and bonded to the first bump;
a second bump bonding pad disposed on the substrate body and bonded to the second bump; and
a first insulating layer disposed on the substrate body,
wherein the first insulating layer defines a first opening, through which the substrate body is exposed in a package division region surrounding the first package region and the second package region,
wherein the first insulating layer defines a second opening adjacent to and extending from the first opening, through which the first bump bonding pad is exposed, and
wherein the first insulating layer defines a third opening adjacent to and extending from the first opening, through which the second bump bonding pad is exposed.

2. The semiconductor package according to claim 1, wherein a mold layer is filled in the first opening, the second opening, and the third opening.

3. The semiconductor package according to claim 1, wherein the mold layer contacts the substrate body exposed through the first opening, the second opening, and the third opening.

4. The semiconductor package according to claim 1,
wherein the first package region is located near the second package region in a first horizontal direction, wherein the first opening comprises:
a first slot located between the first package region and the second package region;
a second slot disposed on an opposite side of the first package region with respect to the first slot in the first horizontal direction; and
a third slot disposed on an opposite side of the second package region with respect to the first slot in the first horizontal direction;
wherein the second opening extends across the first package region in the first horizontal direction, a first end of the second opening is adjacent to the first slot, and a second end of the second opening is adjacent to the second slot of the first opening; and
wherein the third opening extends across the second package region in the first horizontal direction, a first end of the third opening is adjacent to the first slot, and a second end of the third opening is adjacent to the third slot of the first opening.

5. The semiconductor package according to claim 4, wherein the second opening is aligned with the third opening in the first horizontal direction.

6. The semiconductor package according to claim 4, wherein the second opening comprises:
a first recess adjacent to the first slot of the first opening;
a second recess adjacent to the second slot of the first opening; and
a first cavity between the first recess and the second recess;
wherein, in a second horizontal direction perpendicular to the first horizontal direction, a width of at least one of the first recess and the second recess is greater than a width of the first cavity.

7. The semiconductor package according to claim 1,
wherein the first opening comprises a first slot disposed on a first side of the first package region and a second slot disposed on a second side of the first package region; and
wherein the second opening is adjacent to one of the first slot and the second slot.

8. The semiconductor package according to claim 1, wherein the package substrate further comprises:
a first through-hole vertically extending through the substrate body exposed through the second opening; and
a second through-hole vertically extending through the substrate body exposed through the third opening.

9. The semiconductor package according to claim 8, wherein the mold layer further comprises:
a first extension filling the first through-hole; and
a second extension filling the second through-hole.

10. The semiconductor package according to claim 9,
wherein the package substrate further comprises a second insulating layer disposed on a lower surface of the substrate body;
wherein the first insulating layer is disposed on an upper surface of the substrate body, and
wherein the mold layer further comprises a bottom mold section disposed below the second insulating layer and connected to the first extension and the second extension.

11. A semiconductor package comprising:
a package substrate;
a semiconductor chip mounted on the package substrate by a bump; and
a mold layer covering the semiconductor chip;
wherein the package substrate comprises:
a substrate body;
a bump bonding pad disposed on an upper surface of the substrate body and bonded to the bump; and
a first insulating layer disposed on the upper surface of the substrate body,
wherein the first insulating layer defines a first opening extending from a side surface of the substrate body, through which the bump bonding pad is exposed.

12. The semiconductor package according to claim 11, wherein the first opening is filled with the mold layer.

13. The semiconductor package according to claim 11, wherein the mold layer contacts the upper surface of the substrate body exposed through the first opening.

14. The semiconductor package according to claim 11,
wherein the substrate body comprises a first side surface facing opposite to a second side surface in a first horizontal direction; and
wherein a first end of the first opening is adjacent to the first side surface, and a second end of the first opening is adjacent to the second side surface.

15. The semiconductor package according to claim 14, wherein the first opening comprises:
a first recess adjacent to the first side surface of the substrate body;
a second recess adjacent to the second side surface of the substrate body; and
a cavity between the first recess and the second recess;
wherein, in a second horizontal direction perpendicular to the first horizontal direction, a width of at least one of the first recess and the second recess is greater than a width of the cavity.

16. The semiconductor package according to claim 11,
wherein the substrate body comprises a first side surface facing opposite to a second side surface;
wherein the first opening is adjacent to at least one of the first side surface and the second side surface.

17. The semiconductor package according to claim 11, wherein the package substrate further comprises a through-hole vertically extending through the substrate body exposed through the first opening.

18. The semiconductor package according to claim 17, wherein the mold layer further comprises an extension filling the through-hole.

19. The semiconductor package according to claim 18,
wherein the package substrate further comprises a second insulating layer disposed on a lower surface of the substrate body;
wherein the mold layer further comprises a bottom mold section disposed below the second insulating layer and connected to the extension.

20. A package substrate comprising:
a substrate body;
a first bump bonding pad disposed on the substrate body in a first package region;
a second bump bonding pad disposed on the substrate body in a second package region; and
a first insulating layer disposed on the substrate body,
wherein the first insulating layer defines a first opening, through which the substrate body is exposed in a package division region surrounding the first package region and the second package region,
wherein the first insulating layer defines a second opening adjacent to and extending from the first opening, through which the first bump bonding pad is exposed, and
wherein the first insulating layer defines a third opening adjacent to and extending from the first opening, through which the second bump bonding pad is exposed.
